# EUROPÄISCHE PATENTANMELDUNG

(11) **EP 1 187 192 A2**
(43) Veröffentlichungstag der Anmeldung: **13.03.2002**
(21) Anmeldenummer: 01120084.7
(22) Anmeldetag: 21.08.2001
(51) Int. Cl.: H01L 21/768

(54) **Verfahren zur Herstellung einer elektrisch leitenden Verbindung**

(30) Priorität: 28.08.2000 DE 10042235
(71) Anmelder: Infineon Technologies AG, 81669 München (DE)
(72) Erfinder: Schindler, Günther, 80802 München (DE); Schnabel, Rainer Florian, 85635 Höhenkirchen (DE); Hasler, Barbara, 82131 Stockdorf (DE); Weinrich, Volker, 75014 Paris (FR)
(74) Vertreter: Ginzel, Christian

(57) **Zusammenfassung**

Die Erfindung beschreibt ein Verfahren zur Herstellung einer leitenden Verbindung durch isolierende Schichten mittels eines Kontaktlochs und leitender Materialien, mit denen das Kontaktloch gefüllt wird. Das erfindungsgemäße Verfahren ermöglicht die Herstellung eines weinglasartigen Kontaktlochs (6), in das leitendes Füllmaterial (60) und Barrierenschichten (62,63) ohne die bekannten Probleme wie Hohlraumbildung, Überätzungsgräben und Dielektrischer "Close-Off" eingebracht werden können. Auf diese Weise kann z.B. eine elektrische Verbindung zwischen Diffusionsgebiet (52) eines Auswahltransistors (54) und unterer Elektrode (70) eines Speicherkapazität hochintegrierter DRAM- und FeRAM-Bauelemente mit nur wenigen Maskenschritten erzeugt werden.

## Beschreibung

Die Erfindung betrifft ein Verfahren zur Herstellung von elektrisch leitenden Verbindungen durch eine oder mehrere isolierende Schichten, wie sie beispielsweise für die Verbindung von Speicherkondensatoren mit den Auswahltransistoren in hochintegrierten FRAMs und DRAMs verwendet werden können.

In hochintegrierten Bauteilen dienen elektrisch leitende Verbindungen bzw. Kontakte in der Regel dazu, zwischen elektrisch leitenden Abschnitten, die sich in unterschiedlichen Strukturebenen befinden, einen elektrischen Stromfluß zu ermöglichen. Entsprechend dem Material der oberen bzw. unteren leitenden Strukturebene kommt es beispielsweise zu Silizium/Silizium-Kontakten, Metall/Silizium-Kontakten oder Metall/Metall-Kontakten.

Zur Herstellung derartiger Kontakte wird häufig ein Damascene-Verfahren angewandt. Dazu wird ein Kontaktloch mit einem photolithographischem Schritt durch eine (oder mehrere) isolierende Schicht(en) bis auf einen darunterliegenden Anschluß geätzt. Es folgt eine Beschichtung mit einem leitenden Material, meist dotiertes Polysilizium, welches das geätzte Kontaktloch vollständig auffüllt. Anschließend wird mit Hilfe eines CMP-Schrittes (**C**hemical-**M**echanical **P**olishing) die leitende Schicht bis auf die isolierende Schicht hinab abgetragen, so daß nur noch eine leitende Füllung ("Plug") in dem geätzten Loch übrigbleibt. Der Plug stellt auf diese Weise eine leitende Verbindung von der Oberseite der isolierenden Schicht zur Unterseite der isolierenden Schicht her.

Für einige Kontakte, so z.B. für Kontakte aus Polysilizium, die eine Edelmetallelektrode eines Speicherkondensators mit dem Diffusionsgebiet eines Auswahltransistors verbinden, werden jedoch noch eine oder mehrere zusätzliche leitende Schichten benötigt, die beispielsweise die Diffusion von Sauerstoffatomen oder Metallatomen in oder durch den Kontakt verhindern sollen. Typische Barriereschichten sind beispielsweise Iridium oder Iridiumoxid. Zur Herstellung der Barriere wird in der Regel das Polysilizium durch einen Ätzschritt aus einem oberen Teil des Kontaktlochs entfernt. Nachfolgend wird Barrierematerial abgeschieden und durch einen CMP-Schritt strukturiert, so daß das Barrierematerial nur in dem oberen Teil des Kontaktlochs zurückbleibt. Dabei wird das Barrierematerial bevorzugt durch ein Sputterverfahren abgeschieden.

Leider ergibt sich bei dieser Vorgehensweise das Problem, daß, bedingt durch die immer kleiner werdenden Durchmesser der Kontaktlöcher, das Auffüllen des Kontaktlochs mit dem Barrierematerial immer schwieriger wird. Dies hat zur Folge, daß entweder auf andere aufwendigere Abscheideverfahren, beispielsweise CVD-Verfahren, zurückgegriffen werden muß oder daß mittels einer zusätzlichen Phototechnik eine Vertiefung mit einem größeren Durchmesser überlappend mit dem Kontaktloch erzeugt werden muß. Beide Alternativen haben jedoch erhöhte Produktionskosten zur Folge.

Bei manchen Bauteilen, z.B. FeRAMs, werden in der Regel zwei Barrierenschichten zwischen dem Polysilizium und der unteren Elektrodenschicht des Speicherkondensators verwendet. Die erste Barrierenschicht deckt das Polysilizium des Kontakts ab und verhindert in der Regel die Diffusion von Siliziumatomen durch die Barriere. Die zweite Barrierenschicht deckt die erste Barrierenschicht ab und verhindert in der Regel die Diffusion von Sauerstoff durch die Barriere. Unter Umständen ist weiterhin eine Liner-Schicht zwischen Polysilizium und erster Barrierenschicht erforderlich, die eine gut leitende Haftverbindung zwischen Polysilizium und erster Barrierenschicht bewirkt. Weiterhin kommt es häufig vor, daß die isolierende Schicht aus mindestens zwei Siliziumoxidschichten besteht, welche ein unterschiedliches Ätzverhalten aufweisen.

Wird in diesem Zusammenhang eine elektrisch leitende Verbindung von der unteren Elektrode eines Speicherkondensators zu einem Auswahltransistor hergestellt, so treten eine Reihe von weiteren Problemen auf.

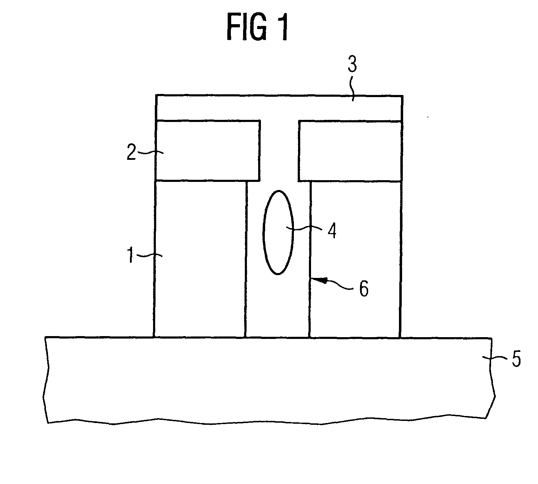

Hohlraumbildung: aufgrund der unterschiedlichen Ätzrate der beiden isolierenden Schichten entsteht bei der Ätzung des Kontaktloches und/oder bei Naßreinigungsschritten vor dem Auffüllen mit dem leitenden Füllmaterial eine Stufe im Kontaktloch entlang der Berührungsfläche der beiden isolierenden Schichten. Bei kleinen Kontaktlochdurchmessern führt diese Stufe bei dem darauf folgenden Beschichtungsprozeß mit dem leitenden Füllmaterial leicht zu einer unvollständigen Füllung, die zu einer Hohlraumbildung, wie in Fig. 1 gezeigt, führen kann. In Fig.1 besteht die untere isolierende Schicht 1 auf dem Halbleitersubstrat 5 aus einem BPSG-Siliziumoxid, während die obere isolierende Schicht 2 aus einem im TEOS-Prozeß hergestellten Siliziumoxid besteht. Aufgrund eines Ätzschrittes oder eines Naßreinigungsschrittes vor dem Füllen des Kontaktloches 6 ist eine Stufe im Kontaktloch 6 an der Grenzschicht der beiden Oxidschichten entstanden. Die leitende Füllschicht 3 besteht aus Polysilizium. Der Hohlraum 4 entsteht beim Beschichten mit dem Polysilizium dadurch, daß die Öffnung der oberen Oxidschicht wegen des kleineren Durchmessers vor dem vollständigen Füllen abschließt.

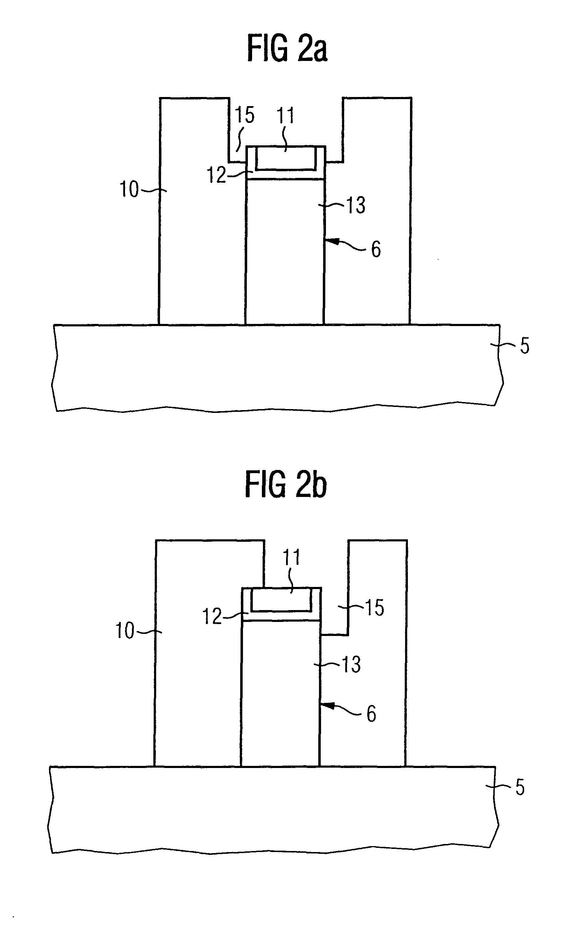

Überätzungsgraben: Um die zweite Barrierenschicht mit Hilfe des Damascene'schen Verfahrens auf die erste Barrierenschicht im Kontaktlochbereich aufzubringen, muß eine Maske auf dem Substrat strukturiert werden, die eine entsprechende Öffnung an der Durchführung aufweisen muß. Beim Ätzen der Maske kann es dabei, z.B. wegen mangelnder Kontrollmöglichkeiten, leicht zu Überätzungen kommen, so daß seitlich an der ersten Barrierenschicht vorbeigeätzt wird, so daß sich ein Graben neben der ersten Barrierenschicht bildet. Dieser Überätzungsgraben kann dazu führen, daß z.B. die noch aufzubringende zweite Barrierenschicht am Rand in der Öffnung mit dem Liner oder mit dem Polysilizium in Berührung kommt, so daß es zur Oxidation des Polysiliziums oder anderen unerwünschten chemischen Reaktionen kommt, die zu Kontaktproblemen führen können. Fig. 2a und Fig. 2b zeigen zwei Bedingungen, unter denen Überätzungsgräben in einer isolierenden Schicht 10 entstehen können: in Fig. 2a ist die Maskenöffnung größer als die Oberfläche der ersten Barrierenschicht 11 und Haftvermittlungsschicht 12, so daß sich ein Überätzungsgraben 15 um die erste Barrierenschicht 11 und die Haftvermittlungsschicht 12 herum bildet. Eine nachfolgende zweite Barrierenschicht würde den Überätzungsgraben 15 füllen und in Kontakt mit dem Liner kommen. In Fig. 2b ensteht ein Überätzungsgraben 15 seitlich durch eine Fehlalignierung der Maskenöffnung bzgl. der Oberfläche der ersten Barrierenschicht 11 und der Haftvermittlungsschicht 12. Eine zweite Barrierenschicht würde den Überätzungsgraben füllen und in diesem Beispiel in Kontakt mit dem Liner 12 und der Polysiliziumfüllung 13 kommen.

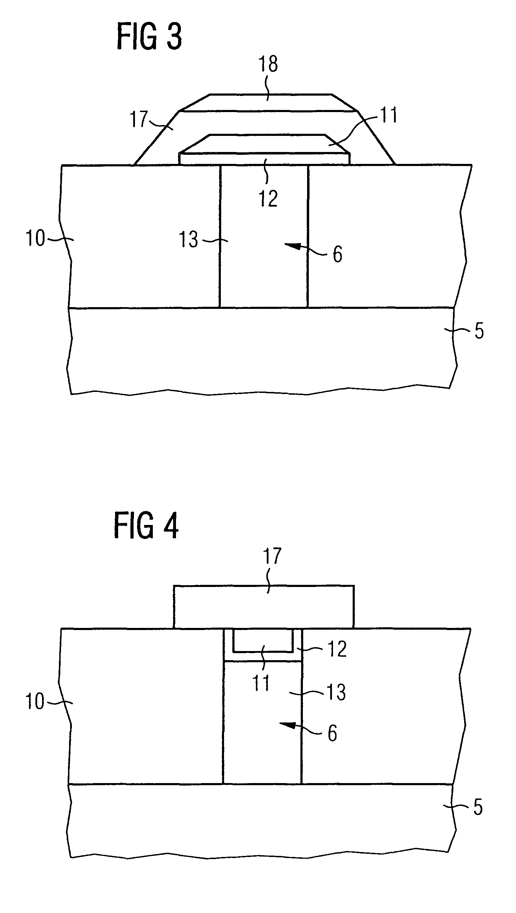

Dielektrischer Abschluß ("Close-Off"): für einen guten und gut leitenden Haftkontakt auf der Polysiliziumschicht benötigt die erste Barrierenschicht gewöhnlich eine Haftvermittlungsschicht, bevorzugt einen Liner, als Zwischenschicht. Der Liner kann jedoch bei Berührung mit der zweiten Barrierenschicht chemisch reagieren, was zu einem dielektrischen Close-Off führen kann. Der Liner sollte daher auch nicht mit der unteren Elektrode oder dem Kondensatordielektrikum in Kontakt stehen. Bei der Herstellung der Barrierenschichten muß daher darauf geachtet werden, daß Liner und zweite Barrierenschicht nicht in Berührung kommen. Fig. 3 und Fig. 4 zeigen zwei Varianten einer leitenden Verbindung durch eine isolierende Schicht 10 auf einem Halbleitersubstrat 5 nach dem Stand der Technik, bei denen die unerwünschten Berührungen zwischen Haftvermittlungsschicht 12 und zweiter Barrierenschicht 17 auftreten. In Fig. 3 ist eine Platinschicht 18 auf der zweiten Barrierenschicht 17 aufgebracht, die wiederum auf einer ersten Barrierenschicht 11, einer Haftvermittlungsschicht 12 und einer Polysiliziumschicht 13 aufliegt. Die kritischen Übergangspunkte zwischen zweiter Barrierenschicht 17 und Haftvermittlungsschicht 12 liegen am Rand der Haftvermittlungsschicht. Nicht viel anders liegt das Problem in Fig. 4.

Der vorliegenden Erfindung liegt daher die Aufgabe zugrunde, ein Verfahren zur Herstellung einer elektrisch leitenden Verbindung anzugeben, das es ermöglicht, die beschriebenen Schwierigkeiten zu vermindern bzw. ganz zu vermeiden und dabei die Anzahl der Prozeßschritte möglichst gering zu halten oder sogar zu reduzieren.

Diese Aufgabe wird von dem Verfahren zur Herstellung einer elektrisch leitenden Verbindung gemäß des unabhängigen Patentanspruchs 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Herstellung einer elektrisch leitenden Verbindung durch eine oder mehrere isolierende Schichten, insbesondere zur Herstellung einer elektrisch leitenden Verbindung zwischen einem Diffusionsgebiet und einer Elektrode, bereitgestellt, das folgende Schritte aufweist:
a) ein Halbleitersubstrat mit zumindest einer isolierenden Schicht wird bereitgestellt;
b) eine Maske wird auf die Oberseite der isolierenden Schicht aufgebracht;
c) ein im wesentlichen isotroper Ätzschritt wird durchgeführt;
d) ein im wesentlichen anisotroper Ätzschritt wird durchgeführt bis die Unterseite der isolierenden Schichten erreicht und ein Kontaktloch erzeugt ist;
e) die Maske wird entfernt;
f) das Kontaktloch wird mit einem ersten leitenden Material gefüllt;
g) das erste leitende Material wird bis zu einer vorgegebenen Höhe zurückgeätzt,
h) der freie Bereich des Kontaktlochs wird mit zumindest einem zweiten leitendem Material gefüllt.

Das erfindungsgemäße Verfahren besitzt den Vorteil, daß man mit nur einem Maskenschritt eine weinglasähnliche Kontaktlochform erhalten kann, die im wesentlichen dem Erfordernis nach einem Kontaktloch mit kleiner Kontaktlochfläche im anisotrop geätzten Bereich und einer größeren Kontaktlochfläche im isotrop geätzten Bereich nahekommt. Diese Kontaktlochform erleichtert durch die größere obere Öffnung eine komplette Füllung sowohl mit dem ersten als auch mit dem zweiten leitenden Material. Insbesondere können durch den größeren Durchmesser im oberen Bereich Sputterverfahren zur Abscheidung des zweiten leitenden Materials eingesetzt werden.

Weiterhin ermöglicht diese Kontaktlochform eine leitende Verbindung von einem sehr kleinem Kontakt auf der Unterseite der isolierenden Schichten, z.B. einem Diffusionsgebiet eines Auswahltransistors, zu einer Struktur auf der Oberseite der isolierenden Schichten, die etwas mehr lateralen Raum einnehmen kann wie z.B. eine untere Elektrode eines Speicherkondensators.

Die größere Öffnung des Kontaktloches im oberen Bereich ermöglicht es weiterhin, daß für die Ätzung einer auf dem Kontaktloch zu strukturierenden Maske, z.B. um ein weiteres leitendes Material auf das zweite leitende Material aufzubringen, das zweite leitende Material als Ätzstop dient, so daß es nicht zu den beschriebenen Überätzungsgräben mit den damit verbundenen Problemen kommen kann.

Um ein Kontaktloch mit kleiner Kontaktlochfläche im anisotrop geätzten Bereich und großer Kontaktlochfläche im isotrop geätzten Bereich zu erhalten, benötigt man mit Standardverfahren mindestens zwei Maskenschritte. Die weinglasähnliche Kontaktlochform, die funktional die gleichen Vorteile aufweist wie die im Zwei-Masken-Prozeß hergestellte Kontaktlochform, wird dagegen mit einem Maskenschritt erzeugt. Ein eingesparter Maskenschritt erspart mehrere weitere Prozeßschritte, was zu höherer Ausbeute in der Produktion von fehlerfreien Chips führt und damit hilft, die Kosten zu senken.

Gemäß einer bevorzugten Ausführungsform beträgt das Verhältnis der Kontaktlochfläche im isotrop geätzten Bereich zu der Kontaktlochfläche im anisotrop geätzten Bereich zwischen 1,5 und 4, bevorzugt zwischen 2 und 3. Weiterhin ist es bevorzugt, wenn das erste leitende Material höchstens bis zu dem anisotrop geätzten Bereich des Kontaktlochs zurückgeätzt wird. Dadurch wird vermieden, daß das zweite leitende Material in den engeren anisotrop geätzten Bereich des Kontaktlochs abgeschieden werden muß.

Bevorzugt wird zwischen dem ersten leitendem Material und dem zweiten leitenden Material eine Haftvermittlungsschicht, insbesondere Titan, Titannitrid, Titansilizid, Tantalnitrid oder Tantal-Silizium-Nitrid, erzeugt. Dabei ist es insbesondere bevorzugt, wenn die Strukturierung der Haftvermittlungsschicht und des zweiten leitenden Materials durch einen gemeinsamen ein- oder mehrstufigen CMP-Schritt erfolgt.

Weiterhin ist es bevorzugt, wenn ein drittes leitendes Material auf das zweite leitende Material aufgebracht wird. Gemäß einer Ausführungsform der vorliegenden Erfindung wird dabei das zweite leitende Material als Landing Pad für das dritte leitende Material verwendet. Auf diese Weise ist die Haftvermittlungsschicht durch das zweite leitende Material gegen einen direkten Kontakt mit dem dritten leiten Material geschützt. Dabei ist es insbesondere bevorzugt, wenn das dritte leitende Material mit Hilfe eines CMP-Verfahrens strukturiert wird.

Gemäß einer weiteren Ausführungsform der vorliegenden Erfindung wird das Kontaktloch durch das zweite leitende Material noch nicht vollständig aufgefüllt, so daß das dritte leitende Material in den noch freien Bereich des Kontaktlochs abgeschieden werden kann. Auf diese Weise kann nochmals eine Maskenebene, die sonst zur Strukturierung des dritten leitenden Materials notwendig gewesen wäre, eingespart werden. Weiterhin kommt es auch in dieser Konfiguration zu keinem direkten Kontakt zwischen der Haftvermittlungsschicht und dem dritten leitendem Material.

Dabei ist es insbesondere bevorzugt, wenn die Strukturierung des zweiten und des dritten leitenden Materials (und gegebenenfalls der Haftvermittlungsschicht) durch einen gemeinsamen ein- oder mehrstufigen CMP-Schritt erfolgt. Hierbei kann es von Vorteil sein, wenn der CMP-Prozeß für das dritte leitende Material selektiv zu dem zweiten leitenden Material ist. Auf diese Weise können die beiden Materialien getrennt voneinander kontrollierbar durch die Polierflüssigkeit abgetragen werden.

Gemäß einer bevorzugten Ausführungsform der vorliegenden Erfindung wird als erstes leitendes Material dotiertes Polysilizium verwendet. Weiterhin ist es bevorzugt, wenn als zweites und/oder drittes leitendes Material ein Barrierematerial verwendet wird. Dabei ist es insbesondere bevorzugt, wenn als zweites leitendes Material ein Barrierematerial zur Unterdrückung der Diffusion von Siliziumatomen, insbesondere Iridium, verwendet wird. Weiterhin ist es bevorzugt, wenn als drittes leitendes Material ein Barrierematerial zur Unterdrückung der Diffusion von Sauerstoffatomen, insbesondere Iridiumoxid, verwendet wird. So können beispielsweise die leitenden Verbindungen zwischen den Auswahltransistoren und den Speicherkondensatoren in ferroelektrischen Speicherzellen erzeugt werden. Dementsprechend kann die untere Elektrodenschicht eines ferroelektrischen Kondensators auf das dritte leitende Material aufgebracht werden.

Gemäß einer bevorzugten Ausführungsform der vorliegenden Erfindung wird vor der Erzeugung einer Elektrode eine Ätzstopschicht, insbesondere eine Siliziumnitridschicht, aufgebracht, wobei die Ätzstopschicht vor dem Aufbringen der Elektrodenschicht an der späteren Auflagestelle der Elektrode geöffnet wird. Die untere Elektrode des Speicherkondensators kann beispielsweise durch ein Damascene-Verfahren strukturiert werden. Die Ätzstopschicht schützt beim folgenden Abtragen einer während des Damascene-Verfahren verwendeten Oxidschicht vor Überätzungsgräben. Bevorzugt wird diese Oxidschicht anschließend wieder abgetragen, um auch die Seitenwände der unteren Elektrode als kapazitätsgebende Fläche für die Speicherung von Ladung zur Verfügung zu haben.

Prozeßbedingt kann es dazu kommen, daß die Isolationsschicht aus einer unteren isolierenden Schicht, einer oberen isolierenden Schicht und möglicherweise weiteren isolierenden Schichten dazwischen besteht. In diesem Fall ist es vorteilhaft, wenn die isotrope Ätzung bis in die untere isolierende Schicht hineinreicht. Da auf diese Weise eventuelle Kontaktlochstufen im weiten, istrop geätzten Kontaktlochbereich liegen, kann die Bildung von Hohlräumen bei der Abscheidung des ersten leitenden Materials zuverlässig verhindert werden.

Die Erfindung wird nachfolgend anhand von Figuren der Zeichnung näher dargestellt. Es zeigen:
- Fig. 1 - 4: Verschiedene leitende Verbindungen durch eine oder mehrere isolierende Schichten nach dem Stand der Technik.
- Fig. 5 - 11: Ein erfindungsgemäßes Verfahren zur Herstellung einer elektrisch leitenden Verbindung von einem Halbleitersubstrat durch eine isolierende Schicht zu einem Speicherkondensator, wobei das Kontaktloch nur eine Barrierenschicht enthält.
- Fig. 12 - 15: Ein weiteres erfindungsgemäßes Verfahren zur Herstellung einer elektrisch leitenden Verbindung von einem Halbleitersubstrat durch zwei isolierende Schichten zu einem Speicherkondensator, wobei das Kontaktloch zwei Barrierenschichten enthält.

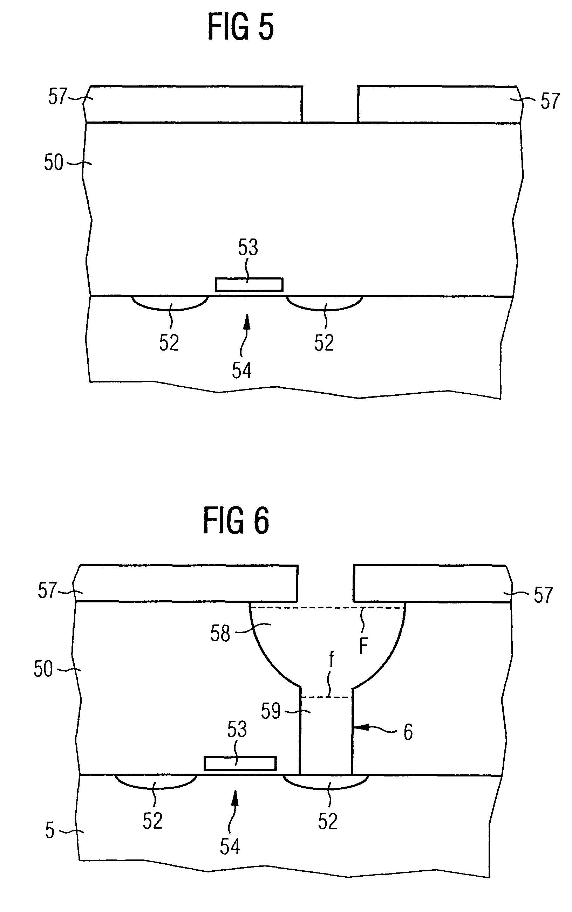

Figure 5 zeigt ein Halbleitersubstrat 5 mit einem Auswahltransistor 54 an der Oberfläche, der aus zwei Diffusionsgebieten 52 und einem Gate 53 besteht. Auf der Halbleitersubstratoberfläche wird eine isolierende Schicht 50 aufgebracht. Im Ausführungsbeispiel ist die isolierende Schicht 50 ein Siliziumoxid, bevorzugt ein BPSG-Oxid oder ein Siliziumoxid aus einem TEOS-Prozeß. Weiterhin ist auf die isolierende Schicht eine Maske 57 aufgebracht, deren Öffnungen Positionen der zu erzeugenden Kontaktlöcher definieren.

Figur 6 zeigt die gleiche Struktur, nachdem die isotrope und anschließend die anisotrope Ätzung durchgeführt worden sind. Im Ausführungsbeispiel ist das weinglasähnliche Kontaktloch erkennbar, das man erhält, wenn die Maskenöffnung im wesentlichen kreisförmig ist. Den "Kelch" des Weinglases erhält man durch die isotrope Ätzung 58, während der "Stiel" des Weinglases durch die anisotrope Ätzung 59 erzielt worden ist. Der Durchmesser des Stieles ist im wesentlichen durch den Durchmesser der Maskenöffnung gegeben. Es sei betont, daß diese vorteilhafte Kontaktlochform mit nur einem Maskenschritt erreicht worden ist. Dabei beträgt im vorliegenden Beispiel das Verhältnis der Kontaktlochfläche F an der Oberfläche im isotrop geätzten Bereich zu der Kontaktlochfläche f im anisotrop geätzten Bereich etwa 2,5.

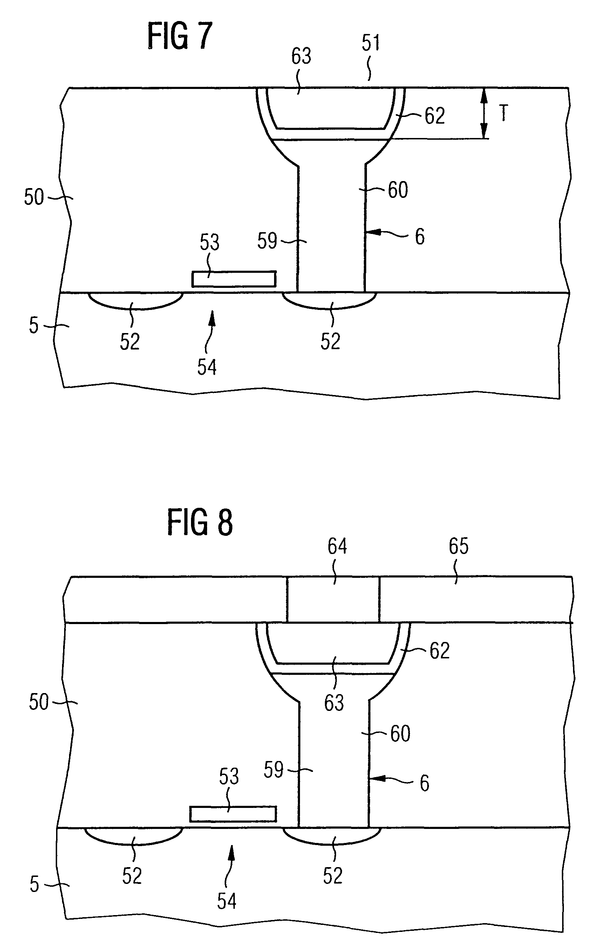

Figur 7 zeigt die Struktur, nachdem die Maske 57 entfernt,mittels einem HF-Dip gereinigt und das Kontaktloch 6 mit leitenden Materialien gefüllt worden ist. Die Füllung ist im Ausführungsbeispiel durch die folgenden Schritte durchgeführt worden: Polysilizium wird in einem CVD Prozeß auf die mit dem Kontaktloch 6 versehene isolierende Schicht 50 aufgetragen und anschließend durch Ätzen oder Polieren wieder bis auf die Oberfläche der isolierenden Schicht 50 abgetragen. Durch weiteres Abätzen wird das im Kontaktloch verbliebene Polysilizium zu einem Teil von oben bis zu einer vorgegebenen Tiefe abgetragen, so daß eine Polysiliziumschicht 60 (erstes leitendes Material) erzeugt worden ist. Die Oberfläche der Polysiliziumschicht 60 liegt bevorzugt im isotrop geätzten Bereich.

Anschließend wird in dem Ausführungsbeispiel eine dünne Haftvermittlungsschicht 62, bevorzugt Titan, Titannitrid, Titansilizid, Tantalnitrid oder Tantal-Silizium-Nitrid, und danach eine dicke erste Barrierenschicht 63 bevorzugt aus Iridium, die das Kontaktloch vollständig ausfüllt, nach herkömmlichem Verfahren aufgetragen und bevorzugt in einem gemeinsamen CMP-Schritt bis auf die Oberfläche der isolierenden Schicht 50 abgetragen. Die erste Barrierenschicht 63 repräsentiert dabei das zweite leitende Material. Das Kontaktloch 6 ist nun gefüllt, wobei die Kontaktlochfläche im isotrop geätzten Bereich 51 im wesentlichen durch die Oberfläche der ersten Barrierenschicht 63 gegeben ist.

Figur 8 zeigt die nächsten Schritte. Eine Maskenschicht 65 aus z.B. Siliziumoxid wird nach herkömmlichem Verfahren aufgetragen und so strukturiert, daß die Maskenöffnungen mit den Kontaktlöchern zusammenfallen. Die Maskenöffnungen sind dabei so klein gewählt, daß sie vollständig von der Oberfläche der ersten Barrierenschicht 63 überdeckt sind. Bei dem Ätzen der Löcher kann so die erste Barrierenschicht 63 als Ätzstop verwendet werden, was die destruktiven Effekte der in Fig. 2 gezeigten Überätzungsgräben vermeidet.

Die Aufbringung und Strukturierung der zweiten Barrierenschicht 64 (drittes leitendes Material), bevorzugt Iridiumoxid, an der Maskenschicht 65 mit Hilfe des Damascene'schen Verfahrens geschieht nach dem Stand der Technik.

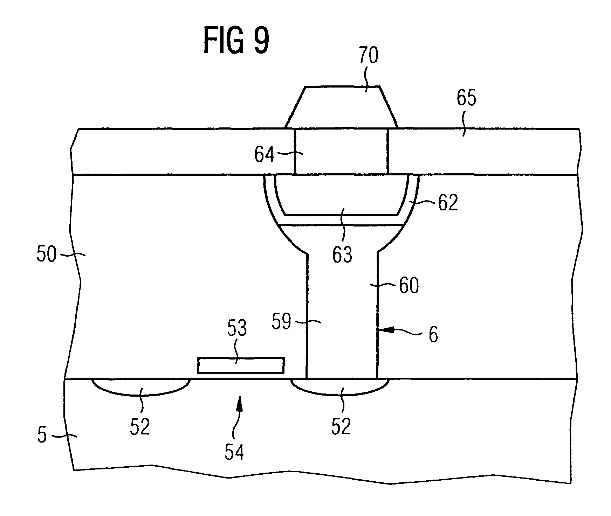

Nun kann in einer ersten Ausführung eine Schicht für die untere Elektrode 70, bevorzugt aus einem Edelmetall oder einem seiner Oxide, insbesondere auch Platin, auf die zweite Barrierenschicht 64 aufgewachsen werden. Die anschließende Strukturierung der unteren Elektrodenschicht 70 kann z.B. durch das nach dem Stand der Technik bekannte RIE-Ätzen geschehen (Fig.9).

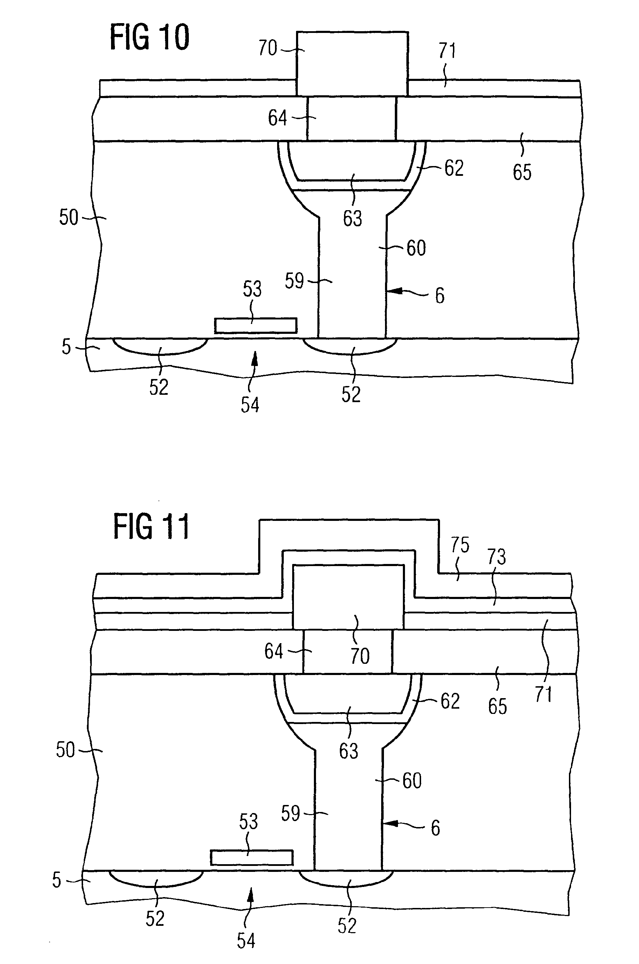

Alternativ kann die Strukturierung der Schicht für die untere Elektrode 70 mit einem weiteren Damascene'schen Prozeßschritt erfolgen, wobei zusätzlich zu der dafür benötigten Maskenschicht auch eine Ätzstopschicht 71 unterhalb der Maskenschicht aufgebracht wird (Fig. 10). Die Ätzschutzschicht ist vorteilhaft, da die Maske nach der Strukturierung der unteren Elektrode 70 wieder abgetragen wird, um auch die Seitenwände der unteren Elektrode 70 mit einer Dielektrikumsschicht bedecken zu können. Letzteres ermöglicht eine maximale Kapazität bei minimaler lateraler Ausdehnung des herzustellenden Speicherkondensators. Im Ausführungsbeispiel ist die untere Elektrode 70 aus Platin und die Ätzschutzschicht 71 aus SiN. Die Schritte zur Herstellung und Strukturierung der unteren Elektrode entsprechen dem Stand der Technik.

Figur 11 zeigt die abschließenden Schritte in der erfindungsgemäßen Ausführung zur Herstellung der Speicherkondensatoren auf dem Kontaktloch: erst wird eine dünne Dielektrikumsschicht 73 auf die untere Elektrode 70 und Umgebung aufgetragen, gefolgt von der oberen Elektrodenschicht 75. Im Ausführungsbeispiel ist die Dielektrikumsschicht 73 aus SBT und die obere Elektrodenschicht 75 aus Platin.

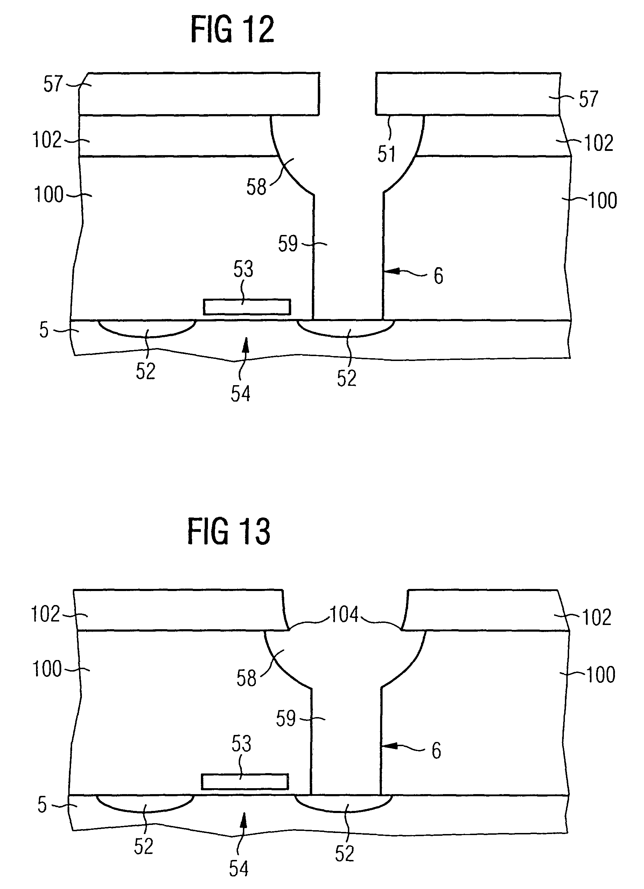

Ein weiteres erfindungsgemäßes Ausführungsbeispiel wird in Fig. 12 bis 15 gezeigt. Im Unterschied zu der vorherigen erfindungsgemäßen Ausführung weist diese Ausführung statt einer isolierenden Schicht eine untere isolierende Schicht 100 und eine obere isolierende Schicht 102 auf. Weiterhin werden erstes, zweites und drittes leitendes Material samt Haftvermittlungsschicht in dem Kontaktloch untergebracht, so daß mindestens ein Maskenschritt eingespart wird.

Fig.12 zeigt das Halbleitersubstrat 5 mit aufgebrachter unterer isolierender Schicht 100, oberer isolierender Schicht 102 und der Maske 57, nachdem erst eine isotrope und dann eine anisotrope Ätzung an einer im wesentlichen runden Maskenöffnung von der oberen isolierenden Schicht 102 bis zum Diffusionsgebiet 52 durchgeführt worden ist. Diese Ätzreihenfolge führt, wie in Fig. 6, zu einem weinglasartigen Kontaktloch 6 mit einer isotropen Ätzlochbereich 58 und einem anisotropen Ätzlochbereich 59. Fig. 12 unterscheidet sich von Fig. 6 lediglich durch das Vorhandensein zweier isolierender Schichten. Die untere isolierende Schicht ist bevorzugt ein BPSG-Oxid, die obere isolierende Schicht bevorzugt ein im TEOS-Verfahren aufgebrachtes Siliziumoxid. In der bevorzugten Ausführung ist die isotrope Ätzung bis in die untere isolierende Schicht durchgeführt, damit mögliche Kontaktlochstufen sich nur im erweiterten Kontaktlochbereich und nicht im engen anisotrop geätzten Bereich ausbilden können. Die Ätzrate beider Oxide bezüglich des Ätzmittels ist in dieser Ausführung weitgehend gleich, so daß sich keine Ätzstufe im Kontaktloch 6 im Übergangsbereich zwischen unterer isolierten Schicht 100 und oberer isolierenden Schicht 102 bildet.

Fig. 13 zeigt das Halbleitersubstrat 5, nachdem die Maske 57 entfernt worden ist und das Halbleitersubstrat 5 einem HF-Dip zur Reinigung unterzogen worden ist. Dieser Reinigungsschritt wird gewöhnlich vor dem Aufbringen der Polysiliziumschicht durchgeführt, bewirkt aber eine selektive Ätzung zwischen den beiden Oxiden der unteren isolierenden Schicht 100 und oberen isolierenden Schicht 102. Dies führt zu der Kontaktlochstufe 104 in dem Kontaktloch am Übergang von unterer isolierender Schicht 100 zur oberen isolierenden Schicht 102. Da die Kontaktlochstufe 104 jedoch im weiten isotropen Ätzbereich 58 liegt, stellt sie für die nun folgende Füllung mit leitenden Materialien kein Problem dar.

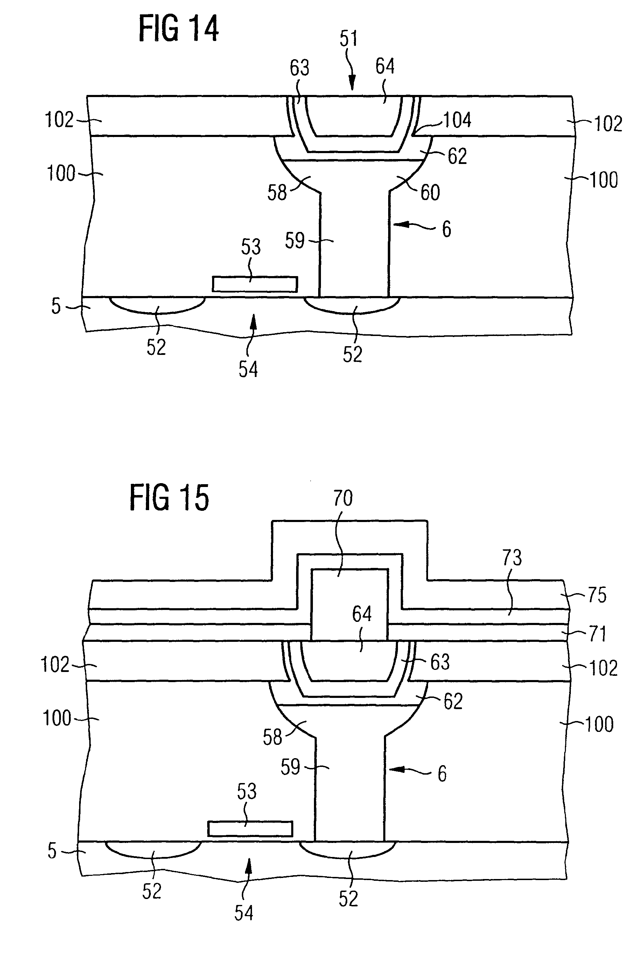

Fig. 14 zeigt das Kontaktloch 6 nach der Füllung mit den drei leitenden Schichten und der Haftvermittlungsschicht 62 mit den folgenden Schritten: nach dem HF-Dip wird eine Polysiliziumschicht aufgetragen, so daß das Kontaktloch 6 gefüllt ist. Anschließend wird die Polysiliziumschicht bis auf die Oberfläche der oberen isolierenden Schicht 102 wieder abgetragen, z.B. durch Ätzen oder einen CMP-Schritt, so daß das Polysilizium nur noch im Kontaktloch 6 verbleibt. Durch weiteres Ätzen wird dann das Polysilizium im Kontaktloch 6 soweit abgeätzt, daß noch weitere leitende Schichten im Kontaktloch untergebracht werden können. In einer bevorzugten Ausführung wird die weitere Ätzung nur soweit gehen, daß die Oberfläche der Polysilizumschicht noch im isotropen Ätzlochbereich 58 verbleibt. Auf diese Weise ist eine Polysiliziumschicht 60, die dem ersten leitenden Material des Anspruchs 1 entspricht, aufgebracht worden.

Anschließend wird eine Haftvermittlungschicht 62, d.h. ein Liner, bevorzugt Titan, Titannitrid, Titansilizid, Tantalnitrid oder Tantal-Silizium-Nitrid, dann eine erste Barrierenschicht 63, die dem zweiten leitenden Material des Anspruchs 1 entspricht und eine zweite Barrierenschicht 64, die dem dritten leitenden Material des Anspruchs 1 entspricht aufgebracht und durch einen ein-, doppel- oder dreistufigen CMP-Schritt geätzt, so daß alle drei leitenden Materialien, d.h. die Polysiliziumschicht 60, die erste Barrierenschicht 63 und die zweite Barrierenschicht 64 samt Haftvermittlungsschicht 62 im Kontaktloch 6 untergebracht sind. Dieses Verfahren spart die meisten Maskenschritte und CMP-Schritte für die Erzeugung einer leitenden Verbindung durch isolierende Schichten mit drei leitenden Materialien ein. Bevorzugte Materialien der ersten Barrierenschicht 63 ist Iridium, das der zweiten Barrierenschicht 64 Iridiumoxid.

Alternativ können der Schichtauftrag der leitenden Materialien einschließlich Haftvermittlungsschicht 62 und das Strukturieren mittels CMP-Schritt auch einzeln hintereinander oder in Paaren durchgeführt werden, z.B. können erst die Haftvermittlungsschicht 62 und die erste Barrierenschicht 63 aufgebracht und mittels CMP-Schritt strukturiert werden, und erst danach die zweite Barrierenschicht 51 aufgebracht und strukturiert werden; aber auch andere Reihenfolgen sind möglich.

Nachdem das Kontaktloch 6 gefüllt worden ist, kann in einer Ausführung eine Speicherkapazität mit unterer Elektrode 70, Dielektrikumsschicht 73 und oberer Elektrodenschicht 75 aufgebracht werden (Fig. 15). Dabei dient die Oberfläche der zweiten Barrierenschicht 64 als Landing Pad für die Strukturierung der Maske für die untere Elektrode 70. Die Oberfläche der zweiten Barrierenschicht 64 muß daher die Auflagefläche der unteren Elektrode 70 vollständig überdecken, um Überätzungsgräben zu verhindern. Da die zweite Barrierenschicht 64 mit der Dielektrikumsschicht 73, die für höchstintegrierte Speicher-Bauelemente gewöhnlich Materialien mit sehr hoher Dielektrikumskonstante sind, insbesondere Ferro- und/oder Paraelektrika, chemisch nicht verträglich ist wird eine Ätzschutzschicht 71, meist Siliziumnitrid, auf die obere isolierende Schicht 102 aufgebracht, die die Barrierenschichten 63 und 64 mit Ausnahme des Gebiets, das mit der unteren Elektrode bestückt wird, abdeckt.

Auf die obere isolierende Schicht 102 werden die Ätzschutzschicht 71 und eine Maskenschicht, die vorzugsweise durch das TEOS-Verfahren erzeugt wird, aufgebracht und so strukturiert, daß anschließend eine Schicht für die untere Elektrode 70 auf die Maske aufgegeben und mittels des Damascene'schen Verfahrens an der Maske strukturiert werden kann. Anschließend wird die Maske wieder abgeätzt, damit auch der Rand der unteren Elektrode frei wird für die Dielektrikumsschicht 73 und die obere Elektrodenschicht 75 zur Erhöhung der Speicherkapazität. Die Ätzschutzschicht 71 bleibt jedoch stehen. Anschließend wird die möglichst dünne Dielektrikumsschicht 73 und danach die obere Elektrodenschicht 75 aufgegeben, was durch Verfahren nach Stand der Technik erfolgt.

Die Ausführung ermöglicht es, eine Speicherkondensatorstruktur mit Durchkontaktierung zum Substrat mit insgesamt sieben strukturierten Schichten durch Anwendung von nur zwei Damascene'schen Verfahrensschritten zu erhalten. Wichtiger Bestandteil dieses Verfahrens ist die Benutzung von Kontaktlöchern, die aus einer isotropen und einer anisotropen Ätzung erhalten werden.

## Patentansprüche

1. Verfahren zur Herstellung einer elektrisch leitenden Verbindung durch eine oder mehrere isolierende Schichten, insbesondere zur Herstellung einer elektrisch leitenden Verbindung zwischen einem Diffusionsgebiet und einer Elektrode, mit den folgenden Schritten:
a) ein Halbleitersubstrat mit zumindest einer isolierenden Schicht wird bereitgestellt;
b) eine Maske wird auf die Oberseite der isolierenden Schicht aufgebracht;
c) ein im wesentlichen isotroper Ätzschritt wird durchgeführt;
d) ein im wesentlichen anisotroper Ätzschritt wird durchgeführt, bis die Unterseite der isolierenden Schichten erreicht und ein Kontaktloch erzeugt ist;
e) die Maske wird entfernt;
f) das Kontaktloch wird mit einem ersten leitenden Material gefüllt;
g) das erste leitende Material wird bis zu einer vorgegebenen Tiefe zurückgeätzt,
h) der freie Bereich des Kontaktlochs wird mit zumindest einem zweiten leitenden Material gefüllt.

2. Verfahren nach Anspruch 1,
**dadurch gekennzeichnet, daß**
das Verhältnis der Kontaktlochfläche im isotrop geätzten Bereich zu der Kontaktlochfläche im anisotrop geätzten Bereich zwischen 1,5 und 4, bevorzugt zwischen 2 und 3, beträgt.

3. Verfahren nach Anspruch 1 oder 2,
**dadurch gekennzeichnet, daß**
das erste leitende Material höchstens bis zu dem anisotrop geätzten Bereich des Kontaktlochs zurückgeätzt wird.

4. Verfahren nach einem der vorhergehenden Ansprüche,
**dadurch gekennzeichnet, daß**
zwischen dem ersten leitendem Material und dem zweiten leitenden Material eine Haftvermittlungsschicht, insbesondere Titan, Titannitrid, Titansilizid, Tantalnitrid oder Tantal-Silizium-Nitrid, erzeugt wird.

5. Verfahren nach Anspruch 4,
**dadurch gekennzeichnet, daß**
die Strukturierung der Haftvermittlungsschicht und des zweiten leitenden Materials durch einen einstufigen oder mehrstufigen CMP-Schritt erfolgt.

6. Verfahren nach einem der vorhergehenden Ansprüche,
**dadurch gekennzeichnet, daß**
ein drittes leitendes Material auf das zweite leitende Material aufgebracht wird.

7. Verfahren nach Anspruch 6,
**dadurch gekennzeichnet, daß**
das zweite leitende Material als Landing Pad für das dritte leitende Material verwendet wird.

8. Verfahren nach Anspruch 7,
**dadurch gekennzeichnet, daß**
das dritte leitende Material mit Hilfe eines CMP-Verfahrens strukturiert wird.

9. Verfahren nach Anspruch 6,
**dadurch gekennzeichnet, daß**
das dritte leitende Material in einen freien Bereich des Kontaktlochs abgeschieden wird.

10. Verfahren nach Anspruch 9,
**dadurch gekennzeichnet, daß**
die Strukturierung des zweiten und des dritten leitenden Materials durch einen einstufigen oder mehrstufigen CMP-Schritt erfolgt.

11. Verfahren nach einem der vorhergehenden Ansprüche,
**dadurch gekennzeichnet, daß**
als erstes leitendes Material dotiertes Polysilizium verwendet wird.

12. Verfahren nach einem der vorhergehenden Ansprüche,
**dadurch gekennzeichnet, daß**
als zweites und/oder drittes leitendes Material ein Barrierematerial verwendet wird.

13. Verfahren nach Anspruch 10,
**dadurch gekennzeichnet, daß**
als zweites leitendes Material ein Barrierematerial zur Unterdrückung der Diffusion von Siliziumatomen, insbesondere Iridium, verwendet wird.

14. Verfahren nach Anspruch 10,
**dadurch gekennzeichnet, daß**
als drittes leitendes Material ein Barrierematerial zur Unterdrückung der Diffusion von Sauerstoffatomen, insbesondere Iridiumoxid, verwendet wird.

15. Verfahren nach einem der vorhergehenden Ansprüche,
**dadurch gekennzeichnet, daß**
vor der Erzeugung einer Elektrode eine Ätzstopschicht, insbesondere eine Siliziumnitridschicht, aufgebracht wird.

16. Verfahren nach einem der vorhergehenden Ansprüche,
**dadurch gekennzeichnet, daß**
die Isolationsschicht aus einer unteren isolierenden Schicht und einer oberen isolierenden Schicht besteht und die isotrope Ätzung bis in die untere isolierende Schicht hineinreicht.

17. Verfahren nach einem der vorhergehenden Ansprüche,
**dadurch gekennzeichnet, daß**
die untere Elektrode im Damascene'schen Verfahren strukturiert wird.
